# EUROPEAN PATENT APPLICATION

(11) **EP 4 745 837 A1**
(43) Date of publication of application: **20.05.2026**
(21) Application number: 24855447.9
(22) Date of filing: 21.06.2024
(51) Int. Cl.: G06N 3/02, G06N 3/04, G06F 17/16

(54) **PROCESSOR, FLOATING-POINT OPERATION UNIT, AND OPERATION METHOD**

(30) Priority: 24.08.2023 CN 202311086354
(71) Applicant: Huawei Technologies Co., Ltd., Shenzhen, Guangdong 518129 (CN)
(72) Inventor: WANG, Junsong, Shenzhen, Guangdong 518129 (CN); HU, Tianchi, Shenzhen, Guangdong 518129 (CN); HUANG, Jiangle, Shenzhen, Guangdong 518129 (CN)
(74) Representative: Goddar, Heinz J.
(86) International application number: PCT/CN2024/100795
(87) International publication number: WO 2025/039718

(57) **Abstract**

Embodiments disclosed in this application relate to the field of computing technologies, and in particular, to a processor, a floating-point operation unit, and an operation method. The processor includes a data transfer unit and a floating-point operation unit. In addition to a data transfer module that implements a data transfer function, the data transfer unit further includes a data decompression module. The data decompression module may perform decompression processing on first weight data obtained through compression processing in an AI model, to obtain second weight data represented by a floating point. The data transfer unit may transfer first activation data and the second weight data to the floating-point operation unit for a floating-point operation. According to this application, the floating-point operation may be performed on the first weight data obtained through compression processing and the first activation data on which compression processing is not performed. In this way, when quantization compression is performed on the AI model, compression processing may be performed only on weight data. This can reduce impact of the quantization compression on AI model accuracy.

## Description

This application claims priority to Chinese Patent Application No. 202311086354.8, filed on August 24, 2023 and entitled "PROCESSOR, FLOATING-POINT OPERATION UNIT, AND OPERATION METHOD", which is incorporated herein by reference in its entirety.

### TECHNICAL FIELD

This application relates to the field of computing technologies, and in particular, to a processor, a floating-point operation unit, and an operation method.

### BACKGROUND

Quantization compression on an artificial intelligence (Artificial Intelligence, AI) model is a method of quantizing weight data and activation data in the AI model from floating points to integers, to improve a running speed of the AI model.

Although the quantization compression can improve the running speed of the AI model, the quantization compression reduces AI model accuracy. Because the activation data has a larger numerical range and a specific proportion of outliers, impact of quantization of the activation data on the AI model accuracy is greater than impact of quantization of the weight data on the AI model accuracy.

### SUMMARY

Embodiments of this application provide a processor, a floating-point operation unit, and an operation method, to improve calculation efficiency of calculating activation data and weight data, and reduce impact of quantization compression on AI model accuracy. Corresponding technical solutions are as follows:

According to a first aspect, a processor is provided. The processor includes a data transfer unit and a floating-point operation unit. The data transfer unit implements a data transfer function for the processor and includes a data transfer module and a data decompression module.

The data transfer module is configured to obtain first weight data and first activation data of an artificial intelligence AI model. The first weight data is obtained by performing compression processing on original weight data in the AI model. The data decompression module is configured to perform decompression processing on the first weight data, to obtain second weight data represented by a floating point. The data transfer module is further configured to input the first activation data and the second weight data into the floating-point operation unit for a floating-point operation.

In the solution shown in this application, in a process in which the data transfer module transfers the first weight data and the first activation data to the floating-point operation unit, the data decompression module added to the data transfer unit may perform decompression processing on the first weight data obtained through compression processing, to obtain the second weight data represented by the floating point, and then the data transfer module may input the second weight data and the first activation data on which compression processing is not performed into the floating-point operation unit, to implement the floating-point operation on the weight data and the activation data.

In this way, compression processing is performed only on the weight data in the AI model, so that impact of quantization of the activation data on AI model accuracy can be avoided. In addition, the data decompression module is added to the data transfer unit, so that transferring the first weight data by the data transfer unit to another operation unit (for example, a vector operation core) for the decompression processing is avoided, and efficiency of performing decompression processing on the first weight data can be improved, thereby improving efficiency of performing the floating-point operation on the first activation data and the second weight data by the processor.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In the solution shown in this application, the compression processing may be performing encoding compression on the original weight data in the AI model. For example, the original weight data of FP16 may be encoded into a block floating point (Block Floating Point) format, to obtain the first weight data. In this case, storage space occupied by the weight data in the AI model can be reduced. Correspondingly, when the compression processing is the encoding compression, the corresponding decompression processing is the decoding processing, to be specific, decoding the first weight data obtained through encoding into the second weight data represented by the floating point.

In the solution shown in this application, the compression processing may alternatively be performing quantization compression on the original weight data in the AI model. For example, the original weight data of FP16 may be quantized to the first weight data of INT8. In this case, storage space occupied by the weight data in the AI model can be reduced. Correspondingly, when the compression processing is the quantization compression, the corresponding decompression processing is the numerical conversion, to be specific, converting the first weight data into the second weight data represented by the floating point.

In an implementable manner, the data transfer module includes a data storage and a transfer controller. The transfer controller is configured to store the first weight data in a GM in the data storage, and then input the data storage into the data decompression module. After the data decompression module completes the decompression processing, the second weight data is input into the floating-point operation unit.

In the solution shown in this application, before inputting the first weight data stored in the data storage into the floating-point operation unit, the transfer controller may first input the first weight data into the data decompression module. After the data decoding module decompresses the first weight data into the second weight data, the transfer controller may input the second weight data into the floating-point operation unit. In this case, the decompression processing on the first weight data may be implemented in the data transfer unit, and the first weight data does not need to be transferred to another operation unit for the decompression processing, so that efficiency of performing decompression processing on the first weight data can be improved.

In an implementable manner, the data transfer module includes a data storage and a transfer controller. The transfer controller is configured to input the first weight data in a GM into the data decompression module. After the data decompression module completes the decompression processing, the second weight data is stored in the data storage, and then the second weight data stored in the data storage is input into the floating-point operation unit.

In the solution shown in this application, before transferring the first weight data stored in the GM to the data storage, the transfer controller may first input the first weight data into the data decompression module, and the data decoding module decompresses the first weight data into the second weight data. The transfer controller may store the second weight data in the data storage, and then input the second weight data in the data storage into the floating-point operation unit. In this case, the decompression processing on the first weight data may be implemented in the data transfer unit, and the first weight data does not need to be transferred to another operation unit for the decompression processing, so that efficiency of performing decompression processing on the first weight data can be improved.

In an implementable manner, the data transfer unit uses direct memory access DMA or tensor memory access TMA.

In an implementable manner, the floating-point operation unit is a matrix operation core.

According to a second aspect, a floating-point operation unit is provided. The floating-point operation unit includes a data buffer module, a data decompression module, and a data calculation module. The data buffer module is configured to buffer first weight data and first activation data of an artificial intelligence AI model. The first weight data is obtained by performing compression processing on original weight data in the AI model. The data decompression module is configured to perform decompression processing on the first weight data, to obtain second weight data represented by a floating point. The data calculation module is configured to perform a floating-point operation on the first activation data and the second weight data, to obtain an operation result.

In the solution shown in this application, the floating-point operation unit may be a unit that is in a processor and that performs the floating-point operation on the weight data and the activation data in the AI model. The data decompression module is added to the floating-point operation unit. In this way, decompression processing may be performed, in the floating-point operation unit, on the first weight data obtained through compression processing, to obtain the second weight data represented by the floating point, and then the floating-point operation unit may perform the floating-point operation on the first activation data and the second weight data.

In this way, compression processing is performed only on the weight data in the AI model, so that impact of quantization of the activation data on AI model accuracy can be avoided. In addition, the data decompression module is added to the floating-point operation unit, so that transferring the first weight data to another operation unit (for example, a vector operation core) for the decompression processing is avoided, and efficiency of performing decompression processing on the first weight data can be improved, thereby improving efficiency of performing the floating-point operation on the first activation data and the second weight data.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In the solution shown in this application, the compression processing may be performing encoding compression on the original weight data in the AI model. For example, the original weight data of FP16 may be encoded into a block floating point (Block Floating Point) format, to obtain the first weight data. In this case, storage space occupied by the weight data in the AI model can be reduced. Correspondingly, when the compression processing is the encoding compression, the corresponding decompression processing is the decoding processing, to be specific, decoding the first weight data obtained through encoding into the second weight data represented by the floating point.

In the solution shown in this application, the compression processing may alternatively be performing quantization compression on the original weight data in the AI model. For example, the original weight data of FP16 may be quantized to the first weight data of INT8. In this case, storage space occupied by the weight data in the AI model can be reduced. Correspondingly, when the compression processing is the quantization compression, the corresponding decompression processing is the numerical conversion, to be specific, converting the first weight data into the second weight data represented by the floating point.

In an implementable manner, the data buffer module includes a local buffer, an activation matrix register, and a weight matrix register. The local buffer is configured to buffer the first weight data and the first activation data, input the first weight data into the weight matrix register, and input the first activation data into the activation matrix register. The weight matrix register is configured to input the first weight data into the data decompression module. The activation matrix register is configured to input the first activation data into the data calculation module.

In the solution shown in this application, the first weight data and the first activation data may form a matrix, to perform a floating-point matrix operation. The data buffer module may first buffer the first weight data and the first activation data, and then the first weight data may be input into the weight matrix register, and the first activation data may be input into the activation matrix register. Before the first weight data in the weight matrix register is input into the data calculation module, the first weight data may be first input into the data decompression module for the decompression processing, to obtain the second weight data. In this case, the data calculation module may perform a matrix operation on the second weight data and the first activation data. In this way, the data decompression module is added to the floating-point operation unit, so that transferring the first weight data to another operation unit (for example, a vector operation core) for the decompression processing is avoided, and efficiency of performing decompression processing on the first weight data can be improved, thereby improving efficiency of performing the floating-point operation on the first activation data and the second weight data.

In an implementable manner, the floating-point operation unit includes a plurality of data decompression modules.

In the solution shown in this application, because the first weight data has undergone the compression processing, the data buffer module may store more first weight data than the first activation data. It is set that the first weight data in the data buffer module has undergone the compression processing performed by the plurality of data decompression modules in parallel, so that efficiency of performing decompression processing on the first weight data can be improved.

In an implementable manner, the floating-point operation unit is a matrix operation core.

According to a third aspect, an operation method is provided. The operation method is performed by a processor. The processor includes a data transfer unit and a floating-point operation unit. The data transfer unit implements a data transfer function for the processor and includes a data transfer module and a data decompression module. The operation method includes:

The data transfer module obtains first weight data and first activation data of an artificial intelligence AI model. The first weight data is obtained by performing compression processing on original weight data in the AI model. The data decompression module performs decompression processing on the first weight data, to obtain second weight data represented by a floating point. The data transfer module inputs the first activation data and the second weight data into the floating-point operation unit for a floating-point operation.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In an implementable manner, the compression processing includes encoding the original weight data into the first weight data represented by a block floating point. The decoding processing includes decoding the first weight data into the second weight data represented by the floating point.

The quantization compression includes quantizing the original weight data to the first weight data represented by an integer, and the numerical conversion includes converting the first weight data into the second weight data represented by the floating point.

In an implementable manner, the data transfer module includes a data storage and a transfer controller. That the data transfer module obtains the first weight data and the first activation data of the artificial intelligence AI model includes: The transfer controller stores the first weight data in a GM in the data storage, and then inputs the data storage into the data decompression module.

That the data transfer module input the first activation data and the second weight data into the floating-point operation unit includes: The transfer controller inputs the second weight data into the floating-point operation unit after the data decompression module completes the decompression processing.

In an implementable manner, the data transfer module includes a data storage and a transfer controller. That the data transfer module obtains the first weight data and the first activation data of the artificial intelligence AI model includes: The transfer controller inputs the first weight data in a GM into the data decompression module.

That the data transfer module inputs the first activation data and the second weight data into the floating-point operation unit includes: After the data decompression module completes the decompression processing, the transfer controller stores the second weight data in the data storage, and inputs the second weight data stored in the data storage in the floating-point operation unit.

In an implementable manner, the data transfer unit uses direct memory access DMA or tensor memory access TMA.

In an implementable manner, the floating-point operation unit is a matrix operation core.

According to a fourth aspect, an operation method is provided. The operation method is performed by a floating-point operation unit. The floating-point operation unit includes a data buffer module, a data decompression module, and a data calculation module. The operation method includes: The data buffer module buffers first weight data and first activation data of an artificial intelligence AI model. The first weight data is obtained by performing compression processing on original weight data in the AI model. The data decompression module performs decompression processing on the first weight data, to obtain second weight data represented by a floating point. The data calculation module performs a floating-point operation on the first activation data and the second weight data, to obtain an operation result.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In an implementable manner, the compression processing includes encoding the original weight data into the first weight data represented by a block floating point. The decoding processing includes decoding the first weight data into the second weight data represented by the floating point.

The quantization compression includes quantizing the original weight data to the first weight data represented by an integer, and the numerical conversion includes converting the first weight data into the second weight data represented by the floating point.

In an implementable manner, the data buffer module includes a local buffer, an activation matrix register, and a weight matrix register. That the data buffer module buffers the first weight data and the first activation data of the artificial intelligence AI model includes: The local buffer is configured to buffer the first weight data and the first activation data, input the first weight data into the weight matrix register, and input the first activation data into the activation matrix register. The weight matrix register inputs the first weight data into the data decompression module. The activation matrix register is configured to input the first activation data into the data calculation module.

In an implementable manner, the floating-point operation unit includes a plurality of data decompression modules, and the floating-point operation unit is a matrix operation core.

According to a fifth aspect, a computing device is provided. The computing device includes a storage and the processor according to the first aspect. The processor may be configured to implement the operation method according to the third aspect.

According to a sixth aspect, a computing device is provided. The computing device includes a storage and the floating-point operation unit according to the second aspect. The floating-point operation unit may be configured to implement the operation method according to the fourth aspect.

According to a seventh aspect, a computer-readable storage medium is provided. The computer-readable storage medium stores a computer program code, and when the computer program code is executed by a computing device, the computing device is caused to perform the operation method according to the third aspect or the fourth aspect.

According to an eighth aspect, a computer program product including instructions is provided. When the computer program product runs on a computing device, the computing device is caused to perform the operation method according to the third aspect or the fourth aspect.

### BRIEF DESCRIPTION OF DRAWINGS

FIG. 1 is a schematic flowchart of performing an operation on weight data and activation data in a related technology;
FIG. 2 is a diagram of a structure of a computing device according to an embodiment of this application;
FIG. 3 is a diagram of a structure of a processor according to an embodiment of this application;
FIG. 4 is a flowchart of an operation method according to an embodiment of this application;
FIG. 5 is a diagram of a structure of a data transfer unit according to an embodiment of this application;
FIG. 6 is a diagram of a structure of a data transfer unit according to an embodiment of this application;
FIG. 7 is a diagram of performing an operation method on a computing device according to an embodiment of this application;
FIG. 8 is a diagram of a structure of a floating-point operation unit according to an embodiment of this application;
FIG. 9 is a flowchart of an operation method according to an embodiment of this application; and
FIG. 10 is a diagram of performing an operation method on a computing device according to an embodiment of this application.

### DESCRIPTION OF EMBODIMENTS

To make the objectives, technical solutions, and advantages of this application clearer, the following further describes the implementations of this application in detail with reference to the accompanying drawings.

At the beginning of designing an artificial intelligence (Artificial Intelligence, AI) model, to improve AI model accuracy, weight data and activation data are set to floating points with high accuracy, for example, FP32 and FP16. A floating point occupies a large quantity of bits. For example, the floating point of FP32 occupies 32 bits, and the floating point of FP16 occupies 16 bits. Therefore, the floating point needs to occupy a large quantity of storage and computing resources during both storage and operation. Especially, in some large models, for example, a large language model (Large Language Model, LLM), a data amount corresponding to weight data is large, and storage of only the weight data needs to occupy hundreds of GB of storage space.

The AI model may be any trained AI model, for example, a large language model or an image recognition model.

The weight data includes a weight of the trained AI model. In an actual running process of the AI model, the weight data is generally represented in a form of a vector or a matrix.

The activation data may be output data of an intermediate layer of the AI model and is related to sample data that is input into the AI model. In the actual running process of the AI model, the activation data may also be represented in the form of a vector or a matrix, and a vector or matrix operation is usually performed on the activation data and the weight data.

To improve the universality of the AI model, quantization compression is used to reduce the storage space required for storing models and improve a running speed of the AI model. The quantization compression on the AI model is a method of quantizing the weight data and the activation data in the AI model from floating points to integers, to improve the running speed of the AI model. For example, original weight data and original activation data that are of FP16 in the AI model may be quantized to INT8. In this way, storage of one piece of weight data is reduced from 16 bits to 8 bits.

However, converting the floating point into the integer causes a decrease in accuracy of a number. A larger numerical range of the floating point indicates a greater decrease in accuracy during conversion of the floating point into the integer. Therefore, the quantization compression greatly affects the AI model accuracy.

In the AI model, a numerical range of the activation data is generally greater than a numerical range of the weight data, and the activation data has a specific proportion of outliers. As a result, an error caused by quantization of the activation data is larger, and impact of the quantization of the activation data on the AI model accuracy is greater than impact of the quantization of the weight data on the AI model accuracy. In addition, in most AI models, a data amount of the weight data is far greater than a data amount of the activation data. Therefore, performing quantization on the weight data can bring a better quantization effect to the AI model, and the impact of the quantization of the weight data on the AI model accuracy is less than the impact of the quantization of the activation data on the AI model accuracy. Therefore, in a related technology, to ensure the AI model accuracy, asymmetric quantization may be used. In other words, quantization is performed only on the weight data, and is not performed on the activation data.

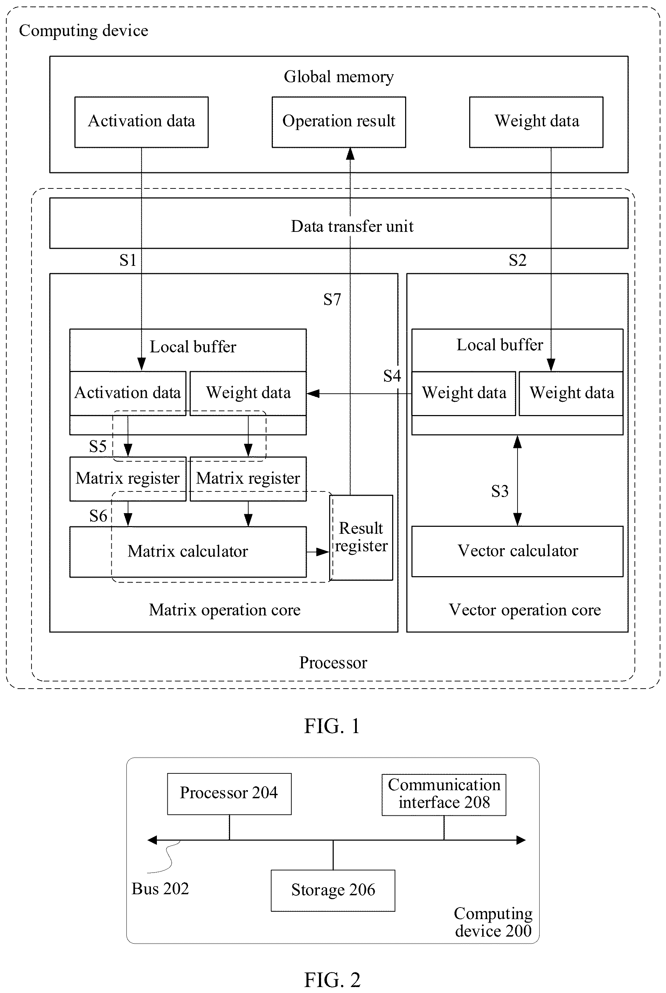

FIG. 1 is a schematic flowchart of performing, by a processor when asymmetric quantization is used in a related technology, an operation on weight data obtained through quantization and activation data on which quantization is not performed. The processor includes a matrix operation core, a vector operation core, and a data transfer unit. The data transfer unit may use direct memory access (direct memory access, DMA), or may use tensor memory access (tensor memory access, TMA). As shown in FIG. 1, the data transfer unit is configured to implement a data transfer function for the processor, and an operation process includes the following steps.

S1: The data transfer unit may write activation data stored in a global memory (global memory, GM) into a local buffer (Local buffer) of the matrix operation core. The activation data is represented by a floating point, for example, FP16.

S2: The data transfer unit may write weight data stored in the GM into a local buffer of the vector operation core. The weight data may be weight data that is represented by an integer and that is obtained by quantizing original weight data in an AI model. For example, the weight data is represented by INT4.

S3: A vector calculator (vector calculation unit) in the vector operation core may convert weight data in a first buffer from the integer into a floating point, and write the floating point obtained through conversion back to the local buffer of the vector operation core.

S4: The data transfer unit may transfer the weight data on which numerical conversion is performed in the local buffer of the vector operation core, that is, the weight data represented by the floating point, to the local buffer of the vector operation core (where a specific transfer process is not shown in the figure).

S5: The local buffer of the matrix operation core separately transmits the activation data and the weight data that are represented by the floating points to two matrix registers.

S6: Input the activation data and the weight data that are buffered in the matrix registers into a matrix calculator (matrix calculation unit) for a corresponding matrix operation, and write an obtained operation result into a result register.

S7: The data transfer unit writes the operation result stored in the result register into the GM, to complete the operation.

It can be learned from FIG. 1 that, to implement an operation on activation data of a floating point and weight data of an integer, the vector operation core needs to convert the weight data of the integer into the weight data of a floating point, and cross-core data transfer needs to be performed by the data transfer unit, to be specific, the weight data of the floating point is transferred from the vector operation core to the matrix operation core. In this case, a large quantity of computing resources and bandwidth resources are occupied, resulting in low operation efficiency.

According to an operation method provided in embodiments of this application, converting weight data of an integer into the weight data of a floating point by a vector operation core can be avoided, and cross-core data transfer implemented by a data transfer unit can be further avoided. This can reduce occupation of computing resources and bandwidth resources, and improve operation efficiency. The operation method provided in embodiments of this application is implemented in a computing device. FIG. 2 is a diagram of a structure of a computing device according to an embodiment of this application. As shown in FIG. 2, the computing device 200 may include a bus 202, a processor 204, and a storage 206. Optionally, the computing device 200 may further include a communication interface 208. The processor 204, the storage 206, and the communication interface 208 communicate with each other through the bus 202. The computing device 200 may be a server or a terminal device. It should be understood that quantities of processors and storages in the computing device 200 are not limited in this application. The computing device 200 may be a device for running a model, and the terminal may also be a server. When the computing device 200 is the terminal, the computing device 200 includes but is not limited to a desktop computer, a mobile phone, a notebook computer, a tablet computer, or the like. When the computing device 200 is the server, the computing device 200 may be an independent server, may be a server cluster including a plurality of servers, may be a physical entity machine, or may be a virtual machine, a container, or the like that is virtualized by using a virtualization technology.

The bus 202 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, only one line is used to represent the bus in FIG. 2, but this does not mean that there is only one bus or one type of bus. The bus 202 may include a path for transmitting information between components (for example, the storage 206, the processor 204, and the communication interface 208) in the computing device 200.

The processor 204 may include any one or more of processors, such as a central processing unit (central processing unit, CPU), a graphics processing unit (graphics processing unit, GPU), a microprocessor (microprocessor, MP), or a digital signal processor (digital signal processor, DSP). The processor 204 may further include a floating-point operation unit and a data transfer unit, and the floating-point operation unit may be a matrix operation core.

The storage 206 may include a volatile memory (volatile memory), for example, a random access memory (random access memory, RAM). The storage 206 may further include a non-volatile memory (non-volatile memory), for example, a read-only memory (read-only memory, ROM), a flash memory, a hard disk drive (hard disk drive, HDD), or a solid-state drive (solid-state drive, SSD). All the foregoing storage may be referred to as a global memory.

The communication interface 208 uses a transceiver module, for example, but not limited to, a network interface card or a transceiver, to implement communication between the computing device 200 and another device or a communication network.

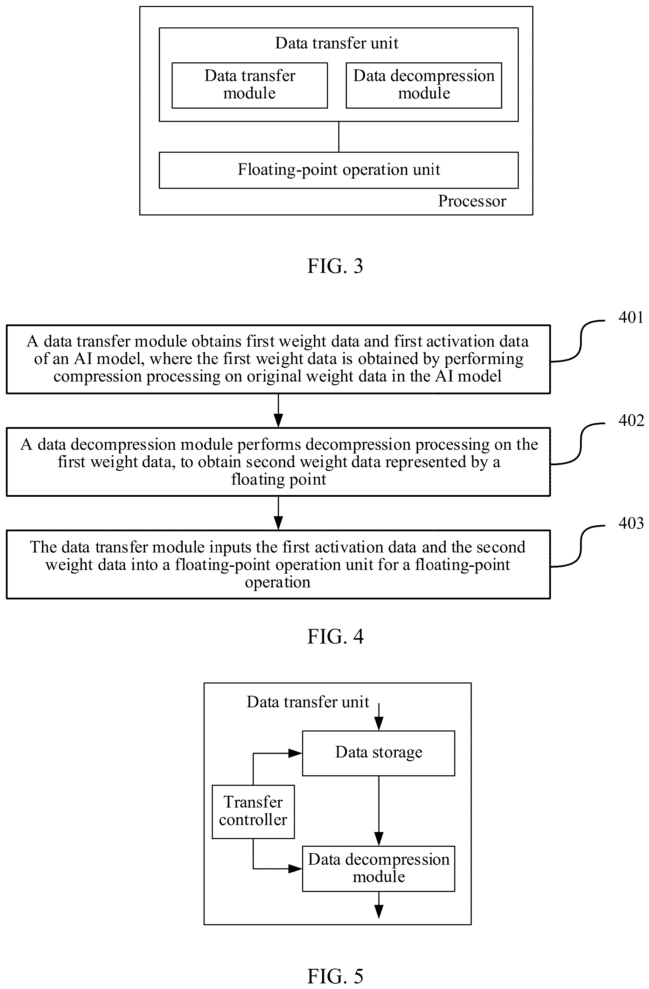

FIG. 3 is a diagram of a structure of a processor according to an embodiment of this application. The processor may be the processor 204 in the computing device in FIG. 2. As shown in FIG. 3, the processor includes a data transfer unit and a floating-point operation unit, and the data transfer unit includes a data transfer module and a data decompression module. The processor may perform an operation method provided in embodiments of this application. FIG. 4 is a flowchart of another operation method according to an embodiment of this application. Refer to FIG. 4. The operation method performed by a processor includes the following steps.

Step 401: A data transfer module obtains first weight data and first activation data of an AI model, where the first weight data is obtained by performing compression processing on original weight data in the AI model.

During implementation, the data transfer module may read the first weight data and the first activation data of the AI model from a GM. The first weight data is obtained by performing compression processing on the original weight data in the AI model. The first activation data is a floating point, and may be activation data on which compression processing is not performed in the AI model.

In this embodiment of this application, the compression processing may include encoding compression and quantization compression. The encoding compression is encoding the original weight data into a specified encoding format, to reduce storage space required for storing the weight data in the AI model. The encoding format may be a block floating point (Block Floating Point) format, or may be an 8-bit floating point (8-bit Efloat) encoding format. The quantization compression is quantizing the original weight data from a floating point to an integer. For example, the original weight data of FP16 may be quantized to the first weight data of INT4. In an implementable manner, the first activation data may alternatively be weight data obtained by performing quantization compression on the original weight data and then performing encoding compression. The compression processing for the first weight data belongs to conventional technologies, and may be performed before running of the AI model. Details are not described in this embodiment of this application.

Step 402: A data decompression module performs decompression processing on the first weight data, to obtain second weight data represented by a floating point.

During implementation, after the data transfer module reads the first weight data and the first activation data of the AI model from the GM, the data transfer module may input the first weight data into the data decompression module for the decompression processing, to obtain the second weight data represented by the floating point.

Corresponding to the foregoing step 401 in which the compression processing includes the encoding compression and the quantization compression, the decompression processing in step 402 includes decoding processing and numerical conversion processing. When the compression processing includes the encoding compression, the decompression processing includes the decoding processing, to be specific, decoding the first weight data obtained through encoding into the floating point. When the compression processing includes the quantization compression, the decompression processing includes the numerical conversion, to be specific, converting the first weight data obtained through quantization compression into the floating point.

In an example, when the compression processing is the encoding compression, the data decompression module is configured to perform decoding processing on the first weight data, for example, decode the first weight data in the block floating point format obtained thorough encoding into an FP16 floating point format, to obtain the second weight data. When the compression processing is the quantization compression, the data decompression module is configured to perform numerical conversion on the first weight data, for example, convert the first weight data represented by INT4 into the second weight data represented by FP16.

In another example, the compression processing is first performing quantization compression on the original weight data, and then performing encoding compression on the weight data obtained through quantization compression. For example, the compression processing may be first quantizing the original weight data represented by FP16 to the weight data represented by INT8, and then performing encoding compression on the weight data represented by INT8. In this case, the data decompression module may include a data decoding submodule and a numerical conversion submodule. The data decoding submodule may first decode the first weight data obtained by the data transfer module, and then the numerical conversion submodule performs numerical conversion on the weight data obtained through decoding, to obtain the second weight data represented by FP16.

The data decompression module is a logic circuit added to a data transfer unit. Based on different decoding processing, a person skilled in the art may add different logic circuits to the data transfer unit, to implement the decompression processing on the first weight data. For example, the logic circuit is added to convert data from INT4 to FP16, or the logic circuit is added to decode data in the block floating point (Block Floating Point) format or the 8-bit Efloat encoding format into data represented by FP16. In addition, in an execution process of this embodiment of this application, a software interface may be configured to indicate whether data decoding needs to be performed on the first weight data by the data decoding module in the data transfer unit.

Step 403: The data transfer module inputs the first activation data and the second weight data into a floating-point operation unit for a floating-point operation.

During implementation, after the data decompression module performs decompression processing on the first weight data to obtain the second weight data, the data transfer unit may store the second weight data and the first activation data in a register in the floating-point operation unit, so that the floating-point operation unit performs the floating-point operation on the second weight data and the first activation data.

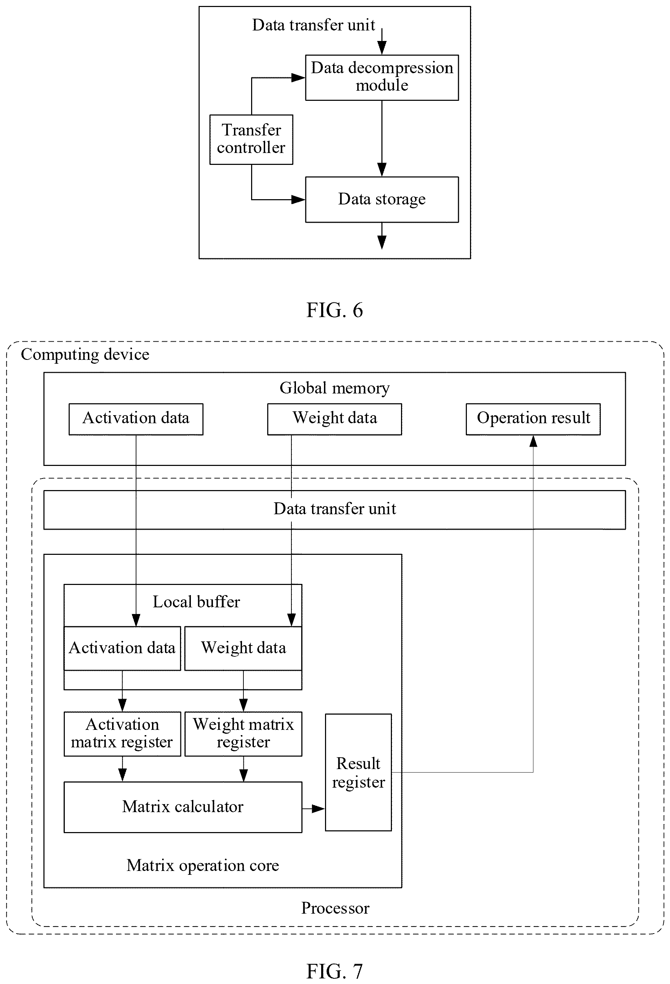

There may be a direct connection path between the data decompression module and the data transfer module, to implement data transmission between the data decompression module and the data transfer module. FIG. 5 and FIG. 6 are diagrams of structures of two types of data transfer units respectively according to embodiments of this application. As shown in FIG. 5 or FIG. 6, the data transfer module may be further divided into a transfer controller and a data storage. The transfer controller is configured to control transfer of data between a memory and/or a register, and the data storage is configured to store the transferred data. For example, processing of transferring the data in the memory to the register may include: The transfer controller reads the data in the memory, and writes the read data into the data storage; and then the transfer controller reads the data in the data storage, and writes the read data into the register in the processor.

As shown in FIG. 5, that the data transfer module inputs the first weight data into the data decompression module for the decompression processing in step 402 may include: The transfer controller stores the first weight data stored in the GM in the data storage, and then inputs the data storage into the data decompression module. After the data decompression module completes the decompression processing, the transfer controller inputs the second weight data into the floating-point operation unit.

During implementation, after reading, from the GM, the first weight data and the first activation data that are to be calculated, the transfer controller may store the first weight data and the first activation data in the data storage, and then input the first weight data stored in the data storage into the data decompression module. The data decompression module performs decompression processing on the first weight data, to obtain the second weight data represented by the floating point. After the data decompression module outputs the second weight data, the transfer controller may store the second weight data and the first activation data in the register in the floating-point operation unit, so that the floating-point operation unit performs the floating-point operation on the second weight data and the first activation data.

As shown in FIG. 6, that the data transfer module inputs the first weight data into the data decompression module for the decompression processing in step 402 may further include: The transfer controller first inputs the first weight data stored in the GM into the data decompression module, and may store the second weight data in the data storage after the data decompression module completes the decompression processing; and then the transfer controller may input the second weight data stored in the data storage into the floating-point operation unit.

During implementation, after reading, from the GM, the first weight data and the first activation data that are to be calculated, the transfer controller may input the first weight data into the data decompression module, and store the first activation data in the data storage. After the data decompression module performs decompression processing on the first weight data to obtain the second weight data represented by the floating point, the transfer controller may store the second weight data and the first activation data in the register in the floating-point operation unit, so that the floating-point operation unit performs the floating-point operation on the second weight data and the first activation data.

In the data transfer units shown in FIG. 5 and FIG. 6, there is a direct connection path between the data storage and the data decompression module, and a transmission rate of the first weight data between the data storage and the data decompression module is far greater than a transmission rate of the first weight data between a matrix operation core and a vector operation core.

In this embodiment of this application, the data decoding module is added to the data transfer unit. In this way, in a process in which the data transfer unit transfers the first weight data, decompression processing may be performed on the first weight data, to obtain the second weight data represented by the floating point. In this way, compression processing is performed only on the weight data in the AI model, so that impact of the quantization compression on AI model accuracy can be reduced when quantization compression is performed on the AI model. In addition, the data decompression module is added to the data transfer unit, so that transferring the first weight data by the data transfer unit to the vector operation core for the decompression processing is avoided, and efficiency of performing decompression processing on the first weight data can be improved, thereby improving efficiency of performing the floating-point operation on the first activation data and the second weight data. Moreover, in comparison with a related technology, in this embodiment of this application, in addition to reducing storage space of the weight data through quantization compression, the storage space of the weight data may be further reduced by performing encoding compression on the weight data.

FIG. 7 is a diagram of performing an operation method on a computing device according to an embodiment of this application. The computing device shown in FIG. 7 includes a global memory and a processor. The processor may be the processor shown in FIG. 3, and a floating-point operation unit in the processor may be a matrix operation core. As shown in FIG. 7, the matrix operation core includes at least a local buffer, matrix registers, a result buffer, and a matrix calculator. The local buffer is configured to buffer first activation data and second weight data that are written by a data transfer unit. The matrix registers are configured to separately store the first activation data and the second weight data in a form of a matrix, and use the first activation data and the second weight data as input matrices of the matrix calculator. The matrix calculator can implement a matrix outer product or a matrix inner product, and is configured to perform a floating-point matrix operation on the first activation data and the second weight data. The result buffer is configured to buffer result data obtained by performing the floating-point matrix operation on the first activation data and the second weight data.

As shown in FIG. 7, the data transfer unit obtains the first activation data and first weight data from the GM, decodes the first weight data into the second weight data, and then may transfer the first activation data and the second weight data to the local buffer in the matrix operation core.

In the matrix operation core, based on a preset tiling (tiling) algorithm for performing the matrix operation on the first activation data and the second weight data, the matrix operation core may store the first activation data in one matrix register in a form of a vector, where the matrix register may be referred to as an activation matrix register or a left matrix register; and the matrix operation core may store the second weight data in the other matrix register in the form of a vector, where the other matrix register may be referred to as a weight matrix register or a right matrix register.

The first activation data and the second weight data that are stored in the activation matrix register and the weight matrix register may be input into the matrix calculator for the floating-point matrix operation. For example, the matrix calculator may perform a matrix inner product operation on the first activation data and the second weight data. After a matrix operation result is obtained, the matrix calculator may store the matrix operation result in the result register. The data transfer unit may then transfer the matrix operation result in the result register to the GM.

It can be learned that, according to the operation method provided in this embodiment of this application, transferring the first weight data by the data transfer unit to a vector operation core for decompression processing can be avoided, and cross-core transmission of the second weight data obtained through decompression can be avoided, thereby improving efficiency of performing a floating-point operation on the first activation data and the second weight data.

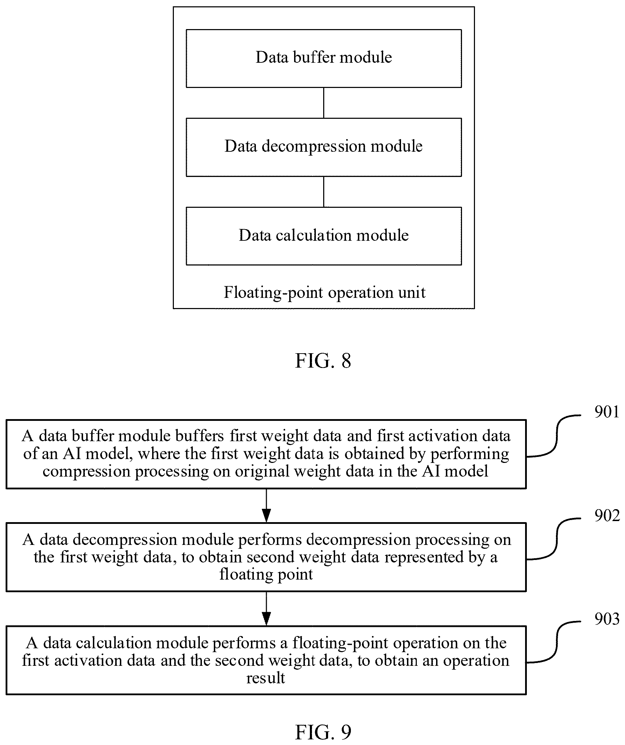

FIG. 8 is a diagram of a structure of a floating-point operation unit according to an embodiment of this application. The floating-point operation unit may be the floating-point operation unit included in the processor 204 in the computing device shown in FIG. 2. As shown in FIG. 8, the floating-point operation unit includes a data buffer module, a data decompression module, and a data calculation module. The data buffer module may be a register in the floating-point operation unit, and is configured to buffer first activation data and first weight data that are to be calculated in an AI model. The data decompression module is configured to perform decompression processing on the first weight data, to obtain second weight data. The data calculation module is configured to perform a floating-point matrix multiplication operation on the first activation data and the second weight data. The floating-point operation unit can implement another operation method provided in embodiments of this application.

FIG. 9 is a flowchart of an operation method according to an embodiment of this application. As shown in FIG. 9, the operation method performed by a floating-point operation unit includes the following steps.

Step 901: A data buffer module buffers first weight data and first activation data in an AI model, where the first weight data is obtained by performing compression processing on original weight data in the AI model.

During implementation, a data transfer module may read the first weight data and the first activation data in the AI model from a GM, and then input the read first weight data and the read first activation data into the data buffer module in the floating-point operation unit. The first weight data is obtained by performing compression processing on the original weight data in the AI model. The first activation data is a floating point, and may be activation data on which compression processing is not performed in the AI model.

In this embodiment of this application, the compression processing may include encoding compression and quantization compression. The encoding compression is encoding the original weight data into a specified encoding format, to reduce storage space required for storing the weight data in the AI model. The encoding format may be a block floating point format, or may be an 8-bit Efloat encoding format. The quantization compression is quantizing the original weight data from a floating point to an integer. For example, the original weight data of FP16 may be quantized to the first weight data of INT4. In an implementable manner, the first activation data may alternatively be weight data obtained by performing quantization compression on the original weight data and then performing encoding compression.

Step 902: A data decompression module performs decompression processing on the first weight data, to obtain second weight data represented by a floating point.

During implementation, the data transfer module may input the buffered first weight data into the data decompression module, and the data decompression module performs the decompression processing on the first weight data, to obtain the second weight data represented by the floating point.

Corresponding to the foregoing step 901 in which the compression processing includes the encoding compression and the quantization compression, the decompression processing in step 902 includes decoding processing and numerical conversion processing. When the compression processing includes the encoding compression, the decompression processing includes the decoding processing, to be specific, decoding the first weight data obtained through encoding into the floating point. When the compression processing includes the quantization compression, the decompression processing includes the numerical conversion, to be specific, converting the first weight data obtained through quantization compression into the floating point.

Step 903: A data calculation module performs a floating-point operation on the first activation data and the second weight data, to obtain an operation result.

During implementation, the data buffer module performs the floating-point operation on the first activation data in the data buffer module and the second weight data obtained by performing decompression processing by the data decompression module, to obtain the operation result.

In this embodiment of this application, the data decompression module is added to the floating-point operation unit. In this way, decompression processing may be directly performed on the first weight data obtained through compression processing in the floating-point operation unit, to obtain the second weight data represented by the floating point. Then, the floating-point operation unit may perform the floating-point operation on the first activation data and the second weight data. In this way, compression processing is performed only on the weight data in the AI model, so that impact of quantization of the activation data on AI model accuracy can be avoided. In addition, the data decompression module is added to the floating-point operation unit, so that transferring the first weight data to a vector operation core for the decompression processing is avoided, and efficiency of performing decompression processing on the first weight data can be improved, thereby improving efficiency of performing the floating-point operation on the first activation data and the second weight data. Moreover, in comparison with a related technology, in this embodiment of this application, in addition to reducing storage space of the weight data through quantization compression, the storage space of the weight data may be further reduced by performing encoding compression on the weight data.

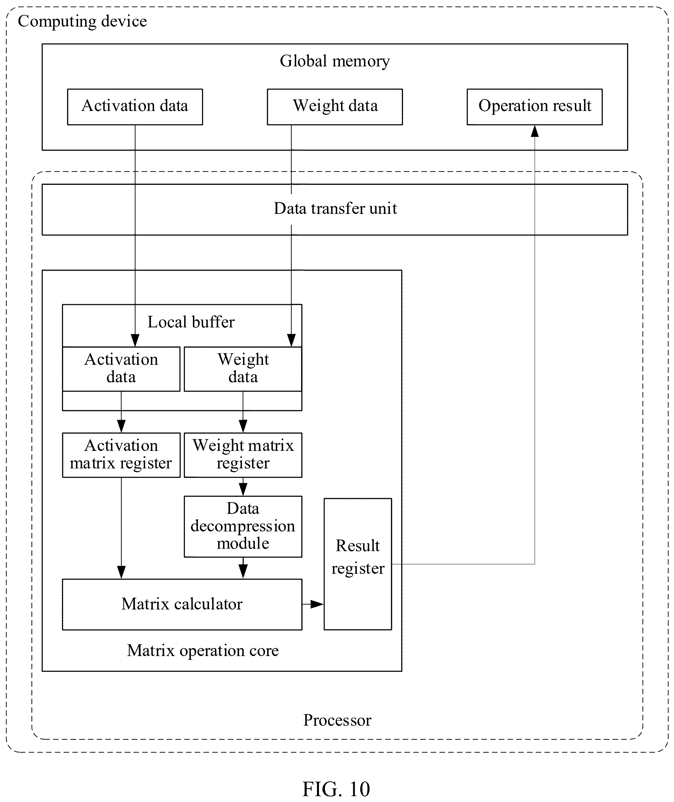

FIG. 10 is a diagram of performing an operation method on a computing device according to an embodiment of this application. The computing device shown in FIG. 10 includes a global memory and a processor. The processor may include the floating-point operation unit shown in FIG. 8. The floating-point operation unit may be a matrix operation core. As shown in FIG. 10, a data buffer module in the matrix operation core includes at least a local buffer, an activation matrix register, a weight matrix register, a result register, and a data decompression module. The local buffer is configured to buffer first activation data and second weight data that are written by a data transfer unit. The matrix registers are configured to separately store the first activation data and the second weight data in a form of a matrix, and use the first activation data and the second weight data as input matrices of a matrix calculator. The result buffer is configured to buffer result data obtained by performing a floating-point matrix operation on the first activation data and the second weight data. The data decompression module is configured to perform decompression processing on weight data obtained through compression processing.

As shown in FIG. 10, after reading the first activation data and first weight data from the GM, the data transfer unit may write the first activation data and the first weight data into the local buffer in the matrix operation core. Then, based on a preset tiling (tiling) algorithm for performing the matrix operation on the first activation data and the first weight data, the processor may store the first activation data in the matrix operation core in one matrix register in a form of a vector, where the matrix register may be referred to as an activation matrix register or a left matrix register; and the processor may store the first weight data in the other matrix register in the form of a vector, where the other matrix register may be referred to as a weight matrix register or a right matrix register.

The first activation data stored in the activation matrix register may be input into a data calculation module in the matrix operation core, that is, the matrix calculator. The first weight data stored in the weight matrix register may be input into the data decompression module located between the weight matrix register and the matrix calculator for the decompression processing. The second weight data obtained by performing decompression processing by the data decompression module may be input into the matrix calculator. Because there is a direct connection path between the data decompression module, the weight matrix register, and the matrix calculator, a transmission rate of the first weight data between the data decompression module, the weight matrix register, and the matrix calculator is far greater than a transmission rate of the first weight data between the matrix operation core and a vector operation core.

The data decompression module is a logic circuit added between the weight matrix register and the matrix calculator. Based on different decoding processing, a person skilled in the art may add different logic circuits to the data transfer unit, to implement the decompression processing on the first weight data. For example, the logic circuit is added to convert data from INT4 to FP16, or the logic circuit is added to decode data in a block floating point (Block Floating Point) format or an 8-bit Efloat encoding format into data represented by FP16. In addition, in an execution process of this embodiment of this application, a software interface may be configured to indicate whether data decoding needs to be performed on the first weight data by a data decoding module in the floating-point operation unit.

In addition, because the matrix calculator is generally designed symmetrically, to be specific, a data bit width corresponding to the second weight data is required to be the same as that corresponding to the first activation data, before the first weight data is input into the data decoding module, zero padding processing may be performed on the first weight data, so that a data bit width of the first weight data is the same as that of the first activation data. In this case, the data decoding module may decompress the first weight data into the second weight data with the same data bit width as that of the first activation data.

The matrix calculator may perform the floating-point matrix operation on the input first activation data and the input second weight data. For example, a matrix inner product operation is performed on the first activation data and the second weight data. The matrix calculator may store an operation result in the result register. The data transfer unit may then transfer the operation result in the result register to the GM.

It can be learned that, according to the operation method provided in this embodiment of this application, transferring the first weight data by the data transfer unit to the vector operation core for the decompression processing can be avoided, and cross-core transmission of the second weight data obtained through decompression can be avoided, thereby improving efficiency of performing a floating-point operation on the first activation data and the second weight data.

In an example, because the first weight data stored in the local buffer and the weight matrix register is weight data obtained through compression processing, the first weight data occupies less storage space. For example, the first weight data is quantized to 4-bit INT4 data. In this way, when storage space is the same, the local buffer and the weight matrix register may store more first weight data. Therefore, a plurality of data decoding modules may be disposed in parallel between the weight matrix register and the matrix calculator. During implementation, the first weight data stored in the weight matrix register may be input into the plurality of data decoding modules for decoding processing, so that decoding efficiency of the first weight data can be further improved, thereby improving operation efficiency of the second weight data and the first activation data.

An embodiment of this application provides a processor. The processor may be the processor shown in FIG. 3, and includes a data transfer unit and a floating-point operation unit. The data transfer unit implements a data transfer function for the processor and includes a data transfer module and a data decompression module. The processor may be configured to implement the operation method shown in FIG. 4.

The data transfer module is configured to obtain first weight data and first activation data of an artificial intelligence AI model. The first weight data is obtained by performing compression processing on original weight data in the AI model.

The data decompression module is configured to perform decompression processing on the first weight data, to obtain second weight data represented by a floating point.

The data transfer module is configured to input the first activation data and the second weight data into the floating-point operation unit for a floating-point operation.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In an implementable manner, the compression processing includes encoding the original weight data into the first weight data represented by a block floating point, and the decoding processing includes decoding the first weight data into the second weight data represented by the floating point. The quantization compression includes quantizing the original weight data to the first weight data represented by an integer, and the numerical conversion includes converting the first weight data into the second weight data represented by the floating point.

In an implementable manner, the data transfer module includes a data storage and a transfer controller. The transfer controller is configured to store the first weight data in a GM in the data storage, and then input the data storage into the data decompression module. The transfer controller is configured to input the second weight data into the floating-point operation unit after the data decompression module completes the decompression processing.

In an implementable manner, the data transfer module includes a data storage and a transfer controller. The transfer controller is configured to input the first weight data in a GM into the data decompression module. The transfer controller is further configured to store the second weight data in the data storage after the data decompression module completes the decompression processing, and input the second weight data stored in the data storage into the floating-point operation unit.

In an implementable manner, the data transfer unit uses direct memory access DMA or tensor memory access TMA. The floating-point operation unit is a matrix operation core.

Processing of implementing an operation on the first weight data and the first activation data by the processor provided in this embodiment of this application and content of the operation method corresponding to FIG. 4 in the foregoing embodiment belong to a same inventive concept. For a specific implementation process, refer to the foregoing method embodiment. Details are not described herein again. According to the processor provided in this embodiment of this application, in a process in which the data transfer unit transfers the first weight data, the data decoding module in the data transfer unit may perform decompression processing on the first weight data, to obtain the second weight data represented by the floating point. In this way, compression processing is performed only on the weight data in the AI model, so that impact of the quantization compression on AI model accuracy can be reduced when quantization compression is performed on the AI model. In addition, the data decompression module is added to the data transfer unit, so that transferring the first weight data by the data transfer unit to a vector operation core for the decompression processing is avoided, and efficiency of performing decompression processing on the first weight data can be improved, thereby improving efficiency of performing the floating-point operation on the first activation data and the second weight data.

An embodiment of this application provides a floating-point operation unit. The floating-point operation unit may be an operation core that is in a processor and that performs a floating-point operation, for example, may be the floating-point operation unit shown in FIG. 8, and includes a data buffer module, a data decompression module, and a data calculation module. The floating-point operation unit may be configured to implement the operation method shown in FIG. 9.

The data buffer module is configured to buffer first weight data and first activation data of an artificial intelligence AI model. The first weight data is obtained by performing compression processing on original weight data in the AI model.

The data decompression module is configured to perform decompression processing on the first weight data, to obtain second weight data represented by a floating point.

The data calculation module is configured to perform the floating-point operation on the first activation data and the second weight data, to obtain an operation result.

In an implementable manner, the compression processing includes at least one of encoding compression and quantization compression. When the compression processing includes the encoding compression, the decompression processing includes decoding processing. When the compression processing includes the quantization compression, the decompression processing includes numerical conversion.

In an implementable manner, the compression processing includes encoding the original weight data into the first weight data represented by a block floating point, and the decoding processing includes decoding the first weight data into the second weight data represented by the floating point. The quantization compression includes quantizing the original weight data to the first weight data represented by an integer, and the numerical conversion includes converting the first weight data into the second weight data represented by the floating point.

In an implementable manner, the data buffer module includes a local buffer, an activation matrix register, and a weight matrix register. The local buffer is configured to buffer the first weight data and the first activation data, input the first weight data into the weight matrix register, and input the first activation data into the activation matrix register. The weight matrix register is configured to input the first weight data into the data decompression module. The activation matrix register is configured to input the first activation data into the data calculation module.

In an implementable manner, the floating-point operation unit is a matrix operation core.

Processing of implementing an operation on the first weight data and the first activation data by the floating-point operation unit provided in this embodiment of this application and content of the operation method corresponding to FIG. 9 in the foregoing embodiment belong to a same inventive concept. For a specific implementation process, refer to the foregoing method embodiment. Details are not described herein again. According to the floating-point operation unit provided in this embodiment of this application, before the first weight data is input into the data calculation module, the data decoding module may perform decompression processing on the first weight data, to obtain the second weight data represented by the floating point. In this way, compression processing is performed only on the weight data in the AI model, so that impact of quantization of the activation data on AI model accuracy can be avoided. In addition, the data decompression module is added to the floating-point operation unit, so that transferring the first weight data to a vector operation core for the decompression processing is avoided, and efficiency of performing decompression processing on the first weight data can be improved, thereby improving efficiency of performing the floating-point operation on the first activation data and the second weight data.

An embodiment of this application further provides a computer program product including instructions. The computer program product may be software or a program product that includes instructions and that can be run on a computing device or be stored in any usable medium. When the computer program product is run on at least one computing device, the at least one computing device is enabled to perform the operation method provided in embodiments of this application.

Embodiments of this application further provide a computer-readable storage medium. The computer-readable storage medium may be any usable medium that can be stored by a computing device, or a data storage device, such as a data center, including one or more usable media. The usable medium may be a magnetic medium (for example, a floppy disk, a hard disk drive, or a magnetic tape), an optical medium (for example, a DVD), a semiconductor medium (for example, a solid-state drive), or the like. The computer-readable storage medium includes instructions. The instructions instruct the computing device to perform the operation method provided in embodiments of this application.

In this application, terms such as "first" and "second" are used to distinguish between same items or similar items that have basically same effects and functions. It should be understood that there is no logical or time sequence dependency between "first" and "second", and a quantity and an execution order are not limited. It should also be understood that although the following descriptions use terms such as "first" and "second" to describe various elements, these elements should not be limited by the terms. These terms are simply used to distinguish one element from another. For example, without departing from the scope of various examples, the first weight data may be referred to as the second weight data, and similarly, the second weight data may be referred to as the first weight data. Both the first weight data and the second weight data may be collectively referred to as weight data, and in some cases, may be separate and different weight data.

The term "at least one" in this application means one or more, and the term "a plurality of" in this application means two or more.

The foregoing descriptions are merely specific implementations of this application, but are not intended to limit the protection scope of this application. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A processor, wherein the processor comprises a data transfer unit and a floating-point operation unit, and the data transfer unit implements a data transfer function for the processor and comprises a data transfer module and a data decompression module;
the data transfer module is configured to obtain first weight data and first activation data of an artificial intelligence AI model, wherein the first weight data is obtained by performing compression processing on original weight data in the AI model;
the data decompression module is configured to perform decompression processing on the first weight data, to obtain second weight data represented by a floating point; and
the data transfer module is configured to input the first activation data and the second weight data into the floating-point operation unit for a floating-point operation.

2. The processor according to claim 1, wherein the compression processing comprises at least one of encoding compression and quantization compression;
when the compression processing comprises the encoding compression, the decompression processing comprises decoding processing; and
when the compression processing comprises the quantization compression, the decompression processing comprises numerical conversion.

3. The processor according to claim 2, wherein the compression processing comprises encoding the original weight data into the first weight data represented by a block floating point, and the decoding processing comprises decoding the first weight data into the second weight data represented by the floating point; and
the quantization compression comprises quantizing the original weight data to the first weight data represented by an integer, and the numerical conversion comprises converting the first weight data into the second weight data represented by the floating point.

4. The processor according to any one of claims 1 to 3, wherein the data transfer module comprises a data storage and a transfer controller;
the transfer controller is configured to store the obtained first weight data in the data storage, and then input the data storage into the data decompression module; and
the transfer controller is configured to input the second weight data into the floating-point operation unit after the data decompression module completes the decompression processing.

5. The processor according to any one of claims 1 to 3, wherein the data transfer module comprises a data storage and a transfer controller;
the transfer controller is configured to input the obtained first weight data into the data decompression module; and
the transfer controller is further configured to store the second weight data in the data storage after the data decompression module completes the decompression processing, and input the second weight data stored in the data storage into the floating-point operation unit.

6. The processor according to any one of claims 1 to 5, wherein the data transfer unit uses direct memory access DMA or tensor memory access TMA.

7. The processor according to any one of claims 1 to 6, wherein the floating-point operation unit is a matrix operation core.

8. A floating-point operation unit, wherein the floating-point operation unit comprises a data buffer module, a data decompression module, and a data calculation module;
the data buffer module is configured to buffer first weight data and first activation data of an artificial intelligence AI model, wherein the first weight data is obtained by performing compression processing on original weight data in the AI model;
the data decompression module is configured to perform decompression processing on the first weight data, to obtain second weight data represented by a floating point; and
the data calculation module is configured to perform a floating-point operation on the first activation data and the second weight data, to obtain an operation result.

9. The floating-point operation unit according to claim 8, wherein the compression processing comprises at least one of encoding compression and quantization compression;
when the compression processing comprises the encoding compression, the decompression processing comprises decoding processing; and when the compression processing comprises the quantization compression, the decompression processing comprises numerical conversion.

10. The floating-point operation unit according to claim 9, wherein the compression processing comprises encoding the original weight data into the first weight data represented by a block floating point, and the decoding processing comprises decoding the first weight data into the second weight data represented by the floating point; and
the quantization compression comprises quantizing the original weight data to the first weight data represented by an integer, and the numerical conversion comprises converting the first weight data into the second weight data represented by the floating point.

11. The floating-point operation unit according to any one of claims 8 to 10, wherein the data buffer module comprises a local buffer, an activation matrix register, and a weight matrix register;
the local buffer is configured to buffer the first weight data and the first activation data, input the first weight data into the weight matrix register, and input the first activation data into the activation matrix register;
the weight matrix register is configured to input the first weight data into the data decompression module; and
the activation matrix register is configured to input the first activation data into the data calculation module.

12. The processor according to any one of claims 8 to 11, wherein the floating-point operation unit comprises a plurality of data decompression modules.

13. The processor according to any one of claims 8 to 12, wherein the floating-point operation unit is a matrix operation core.

14. An operation method, performed by a processor, wherein the processor comprises a data transfer unit and a floating-point operation unit, the data transfer unit implements a data transfer function for the processor and comprises a data transfer module and a data decompression module, and the method comprises:
obtaining, by the data transfer module, first weight data and first activation data of an artificial intelligence AI model, wherein the first weight data is obtained by performing compression processing on original weight data in the AI model;
performing, by the data decompression module, decompression processing on the first weight data, to obtain second weight data represented by a floating point; and
inputting, by the data transfer module, the first activation data and the second weight data into the floating-point operation unit for a floating-point operation.

15. An operation method, performed by a floating-point operation unit, wherein the floating-point operation unit comprises a data buffer module, a data decompression module, and a data calculation module, and the method comprises:
buffering, by the data buffer module, first weight data and first activation data of an artificial intelligence AI model, wherein the first weight data is obtained by performing compression processing on original weight data in the AI model;
performing, by the data decompression module, decompression processing on the first weight data, to obtain second weight data represented by a floating point; and
performing, by the data calculation module, a floating-point operation on the first activation data and the second weight data, to obtain an operation result.

16. A computing device, wherein the computing device comprises a storage and the processor according to any one of claims 1 to 7.

17. A computing device, wherein the computing device comprises a storage and the floating-point operation unit according to any one of claims 8 to 12.
